# EUROPEAN PATENT APPLICATION

(11) **EP 3 032 577 A1**
(43) Date of publication of application: **15.06.2016**
(21) Application number: 15194381.8
(22) Date of filing: 12.11.2015
(51) Int. Cl.: H01L 21/67, H01L 21/78

(54) **WAFER MATERIAL REMOVAL**

(30) Priority: 11.12.2014 US 201414566761
(71) Applicant: NXP B.V., 5656 AG Eindhoven (NL)
(72) Inventor: Moeller, Sascha, Redhill, Surrey RH1 1SH (GB); Rohleder, Thomas, Redhill, Surrey RH1 1SH (GB); Albermann, Guido, Redhill, Surrey RH1 1SH (GB); Lapke, Martin, Redhill, Surrey RH1 1SH (GB); Buenning, Hartmut, Redhill, Surrey RH1 1SH (GB)
(74) Representative: Crawford, Andrew

(57) **Abstract**

One example discloses a system for wafer material removal, including: a wafer structures map, identifying a first device structure having a first location and a second device structure having a second location; an material removal controller, coupled to the structures map, and having an material removal beam power level output signal and an material removal beam on/off status output signal; wherein the material removal controller is configured to select a first material removal beam power level and a first material removal beam on/off status corresponding to the first location; and wherein the material removal controller is configured to select a second material removal beam power level and a second material removal beam on/off status corresponding to the second location. Another example discloses an article of manufacture comprises at least one non-transitory, tangible machine readable storage medium containing executable machine instructions for wafer material removal.

## Description

Various example embodiments of systems, methods, apparatuses, devices, articles of manufacture and computer readable mediums for wafer material removal are now discussed.

Mechanical sawing (e.g. blade dicing) of certain wafer materials, such as Silicon, can be an effective way for separating devices on the wafer. However mechanical sawing of other materials, such as relatively fragile *low-k* materials, can cause collateral damage to wafer devices and structures, thereby affecting wafer yield. Such damage may be even greater for *ultra-low-k* dielectric materials.

Fabricated wafers may also include a variety of structures that need to be cut through during chip dicing. For example, the empty portions of sawlanes may be interspersed with sawlanes filled up with process control modules (PCMs) or metal tiling structures. PCMs are fabricated so as to monitor technology specific parameters such as Vₜₕ in CMOS and V_{be} in Bipolars. These structures can be placed across the wafer at specific locations along with the chip produced so that a closer look into the process variation is possible.

In another example, complete integrated circuit structures in a multi-project wafer (MPW) need to be cut through. Such MPWs require single cuts through both empty sawlanes and full high metal density device structures.

Mechanically sawed (e.g. metals) may also clog the sawing blade and thus require more frequent blade cleaning and/or replacement.

### SUMMARY

According to an example embodiment, a system for wafer material removal, comprises: a wafer structures map, identifying a first device structure having a first location and a second device structure having a second location; an material removal controller, coupled to the structures map, and having an material removal beam power level output signal and an material removal beam on/off status output signal; wherein the material removal controller is configured to select a first material removal beam power level and a first material removal beam on/off status corresponding to the first location; and wherein the material removal controller is configured to select a second material removal beam power level and a second material removal beam on/off status corresponding to the second location.

In another example embodiment, the system is at least one of: a system for wafer grooving or a system for wafer cutting.

In another example embodiment, the wafer structures map identifies the device structures and locations based on information from at least one of: a set of wafer reticles or a scan of a wafer surface.

In another example embodiment, the wafer structures map associates with the first device structure: a device structure attribute; a device structure start location; and a device structure stop location.

In another example embodiment, the device structure attribute is at least one of: a device structure thickness, device structure density, a device structure material, a device structure depth or a number of device structure layers.

In another example embodiment, the first device structure is at least one of: a sawlane, a sawlane intersection, a process control device, a low-k dielectric material, a metal structure, a multi-layer structure, an integrated circuit, an oxide layer or a polymer layer.

Another example embodiment, further comprises a wafer material removal map, identifying a previous material removal location corresponding to a portion of the first location; wherein the material removal controller is configured to select a third material removal beam power level and a third material removal beam on/off status corresponding to the previous material removal location; and wherein the third material removal beam power level is less than the first material removal beam power level.

In another example embodiment, the previous material removal location corresponding to the portion of the first location is a sawlane intersection.

In another example embodiment, the material removal controller is configured to select the third material removal beam power level and the third material removal beam on/off status corresponding to a device structure depth at the previous material removal location.

Another example embodiment, further comprises an material removal device configured to generate an material removal beam; wherein the material removal device includes an material removal beam power level modulator coupled to receive the material removal beam power level output signal and in response varying the material removal beam power level; and wherein the material removal device includes an material removal beam on/off status modulator coupled to receive the material removal beam on/off status output signal and in response turn the material removal beam on or off.

In another example embodiment, the material removal device is at least one of: a cutting device or a grooving device.

In another example embodiment, the material removal beam is at least one of: a laser beam, an ion beam, a plasma beam, a water beam, general particle beams, or a combination of two or more beams.

An example article of manufacture comprises at least one non-transitory, tangible machine readable storage medium containing executable machine instructions for wafer material removal: wherein the instructions include: identifying a first device structure on a wafer having a first location and a second device structure on the wafer having a second location; selecting a first material removal beam power level and a first material removal beam on/off status corresponding to the first location; and selecting a second material removal beam power level and a second material removal beam on/off status corresponding to the second location.

In another example embodiment, the instructions further comprise: identifying a previous material removal location corresponding to a portion of the first location; and selecting a third material removal beam power level and a third material removal beam on/off status corresponding to the previous material removal location; wherein the third material removal beam power level is less than the first material removal beam power level.

In another example embodiment, the instructions further comprise: generating an material removal beam; varying the material removal beam power in response to the material removal beam power level selection; and turning the material removal beam on or off in response to the material removal beam on/off status selection.

In another example embodiment, the instructions further comprise: cutting a wafer with the material removal beam.

In another example embodiment, the instructions further comprise: grooving a wafer with the material removal beam; and dicing the wafer a cutting blade.

In another example embodiment, the instructions further comprise: cutting with the material removal beam at least one of: a sawlane, a sawlane intersection, a process control device, a low-k dielectric material, a metal structure, a multi-layer structure, an integrated circuit, an oxide layer or a polymer layer.

The above discussion is not intended to represent every example embodiment or every implementation within the scope of the current or future Claim sets. The Figures and Detailed Description that follow also exemplify various example embodiments.

Various example embodiments may be more completely understood in consideration of the following Detailed Description in connection with the accompanying Drawings, in which:

### BRIEF DESCRIPTION OF THE DRAWINGS

Figures 1A, 1B and 1C show an example laser grooving-dicing process.
Figure 2 is an example wafer material removal system.
Figure 3 shows an example of a multi-project wafer diced with and without the material removal system.
Figure 4 shows examples of intersecting sawlanes created with and without the material removal system.
Figure 5 shows an example wafer layout including a heterogeneous set of device structures in the sawlanes and an example application of the material removal system for dicing the example wafer.
Figure 6 is an example set of instructions for enabling a wafer material removal system.
Figure 7 is an example system for hosting instructions for enabling a wafer material removal system.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

### DETAILED DESCRIPTION

Laser grooving before mechanical sawing can remove some low-k, metal and circuit structures, but often results in a variable groove depth since the metal and other device structures have varying thicknesses and densities. Such inconsistent laser grooving leave trace amounts of materials that also can cause collateral damage and/or clog the dicing blade.

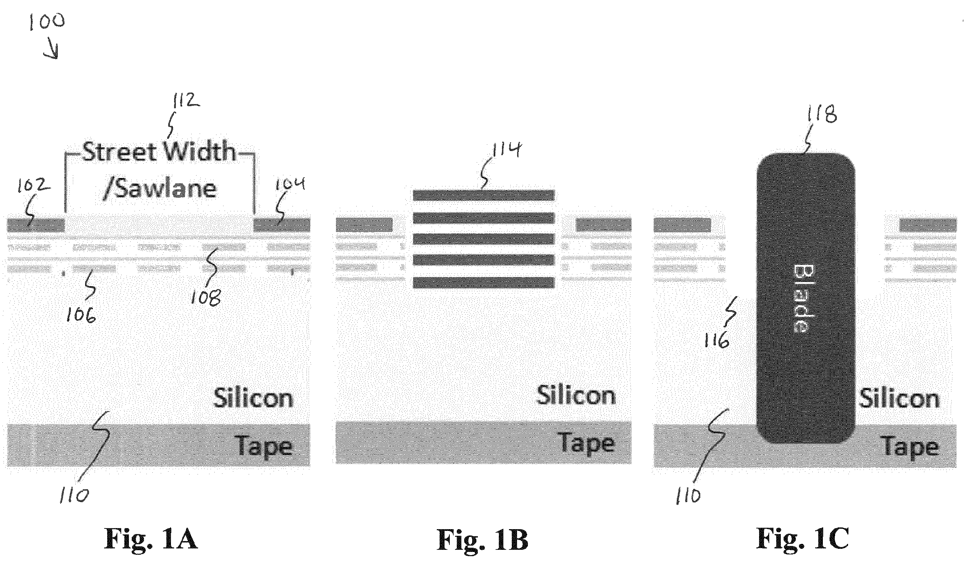

Figures 1A, 1B and 1C show an example 100 laser grooving-dicing process. In Fig. 1A, structures 102, 104, 106, 108 are fabricated upon a silicon wafer 110. A sawlane 112 is defined between two of the structures 102 and 104.

To begin the dicing process, a laser 114 is applied at the sawlane 112 to the structures 106, 108. The structures 106, 108 are then removed thereby creating a groove 116. A dicing blade 118 is applied at the groove 116 to complete the cut through the wafer 110.

If the sawlane 112 only contains structures 106, 108 the groove 116 depth will be rather uniform. However, with variable structures in the sawlane (e.g. PCMs, metal tiling, integrated circuits or empty sawlanes) the groove 116 depth will be variable as well unless either a multiple laser cuts are performed over structures in the sawlane that were not fully cut during the first laser pass, or unless the power of the laser was varied during the first laser material removal (e.g. cutting, grooving, ablating, abrading, wearing away) pass such that a uniform depth was created.

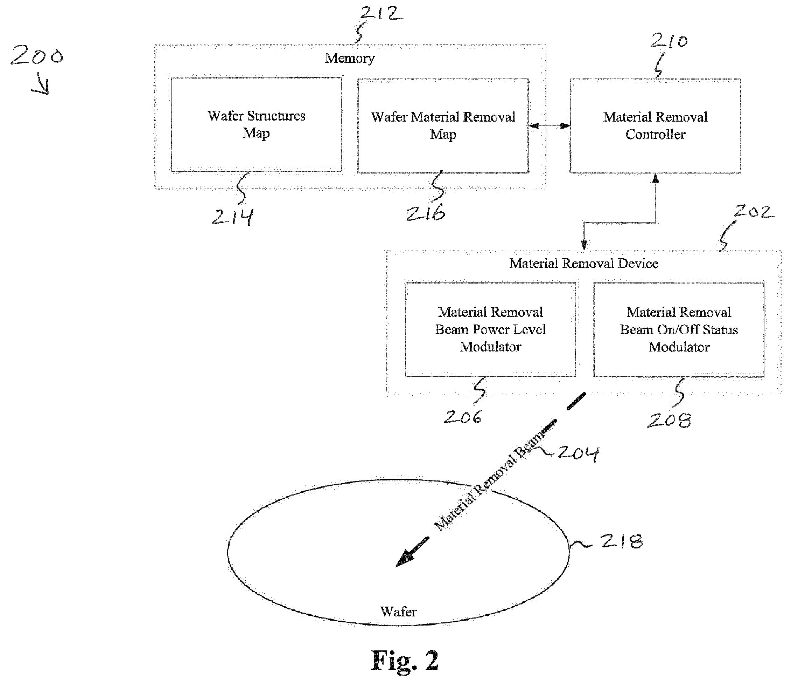

Figure 2 is an example wafer material removal system 200. The material removal system 200 includes an material removal device 202 for generating an material removal beam 204 which removes material from various wafer 218 structures, resulting in either a grooved or cut wafer. The material removal beam 204 in various embodiments can be: a laser beam, an ion beam, a plasma beam, a water beam, general particle beams, or a combination of two or more beams (e.g. a water guided laser beam).

The material removal device 202 controls the material removal beam 204 using a material removal beam power level modulator 206 and an material removal beam on/off status modulator 208.

The material removal beam power level modulator 206 receives a material removal beam power level input signal and in response varies the power level of the material removal beam 204. Such power variation can be either in digital steps or analog in nature. In one example embodiment, the power level is varied while the material removal beam 204 is on, however, in another embodiment the power level can be stored in a data register and is preset to a new power level while the material removal beam 204 is off.

The material removal beam on/off status modulator 208 receives a material removal beam on/off status input signal and in response turn the material removal beam on or off. In one example embodiment, the off state is a quiescent or standby state that does not cause material removal to the wafer 218 structures.

The wafer material removal system 200 includes an material removal controller 210, which is coupled to the material removal device 202. The material removal controller 210 outputs the material removal beam power level signal and the material removal beam on/off status signal to the material removal device 202 for controlling the material removal beam 204.

In one example, the material removal controller 210 set the material removal beam 204 power level and on/off status by retrieving a set of wafer device structure attributes from a memory 212. The memory 212 includes a wafer structures map 214 and a wafer material removal map 216.

In one example embodiment, the wafer structures map 214 includes information on a set of wafer 218 device structures and their location on the wafer 218. This information can be obtained from a set of reticles for fabricating the wafer 218, or a scan of the wafer's 218 surface. The wafer structures map 214 stores a set of attributes for the device structures which in one example include: device structure type, a device structure start location, a device structure stop location and other device structure attributes.

Examples of device structure types include: a sawlane, a sawlane intersection, a process control device, a low-k dielectric material, a metal structure, a multi-layer structure, an integrated circuit, an oxide layer or a polymer layer. Examples of other device structure attributes include: a device structure thickness, device structure density, a device structure material, a device structure depth or a number of device structure layers.

In an example embodiment, the wafer material removal map 216 includes information on a set of wafer 218 device structures which had material previously removed from and the location of the previous material removal. In some examples if a device structure has had material previously removed, the material removal controller 210 will select a lower material removal beam power level or a different material removal beam on/off status for the previously (wholly or partially) removed structure than was selected by the material removal controller 210 when material was removed from the previously structure.

Thus during material removal of a particular data structure on the wafer 218, the material removal controller 210 selects an material removal beam power level and an material removal beam on/off status corresponding to the particular data structure's attributes and whether all or only part of the device structure had been previously removed.

For example, as the material removal beam 204 cuts only a low-k dielectric in a sawlane, the material removal controller 210 selects a low material removal beam power level. However, as the material removal beam 204 cuts a multi-metal layered integrated circuit, the material removal controller 210 selects a high material removal beam power level.

Or for example, as the material removal beam 204 reaches a sawlane intersection which has already been cut once by the material removal beam 204, the material removal controller 210 sets the material removal beam status to off. Then as the material removal beam 204 reaches the other side of the sawlane intersection, the material removal controller 210 sets the material removal beam status to on.

Thus in one example embodiment the material removal controller 210 ensures that each sawlane gets just the amount of power necessary to cut the empty sawlanes and remove variable thickness and density sawlane structures. This creates a uniform groove depth along the whole sawlane.

In various embodiments using the material removal system 200, the material removal beam 204 only needs to pass over various wafer 218 structures once. This is because the wafer structures map 214 and the wafer material removal map 216 in the memory 212 enable the material removal controller 210 to predict the right material removal beam 204 power level and timing to achieve a consistent groove or cut depth which can then be followed by blade dicing if necessary.

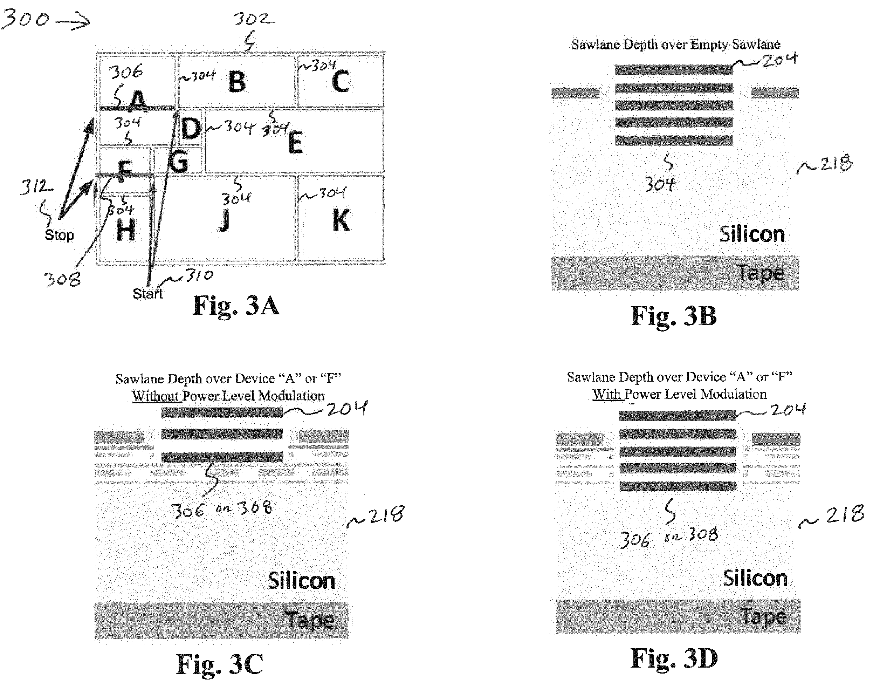

Figure 3 shows an example 300 of a multi-project wafer 302 diced with and without the material removal system 200. Fig. 3A shows the multi-project wafer 302 which includes a set of circuit device structures A, B, C, D, E, F, G, H, J, K, delineated by boundary device structures 304 (e.g. sawlanes). In this example 300 the device structures A and F can be sacrificed to dice one or more of the other device structures.

Fig. 3B shows the material removal beam 204 reaching a first depth in the wafer 218 over an empty sawlane which, in one example, is at the boundary device structure 304 immediately beneath device structures B and C, but not including a device A material removal lane 306, or alternatively immediately above device structures J and K, but not including a device F material removal lane 308. The material removal controller 210 has set the material removal beam 204 to a first material removal beam power level to reach this first depth.

Fig. 3C shows the material removal beam 204 reaching a second depth over device structure A or F when the material removal beam 204 is set to the first material removal beam power level. As shown in Fig. 3C the second depth is shallower than the first depth shown in Fig. 3B and does not cut the whole way through device structures A or F.

Fig. 3D shows the material removal beam 204 reaching the first depth over device structure A or F if the material removal beam's 204 power level was instead increased to a second material removal beam power level at a start 310 point and until a stop 312 point. As shown in Fig. 3D the material removal beam 204 has cut the whole way through device structures A or F.

Thus if the material removal beam 204 power is not increased at the start 310 point, the high metal density or other structural differences in devices A and F results in a shallower grooving depth. However by increasing the material removal beam 204 power level over devices A and F, results in an equivalent grooving depth to that of the empty sawlane shown in Fig. 3B.

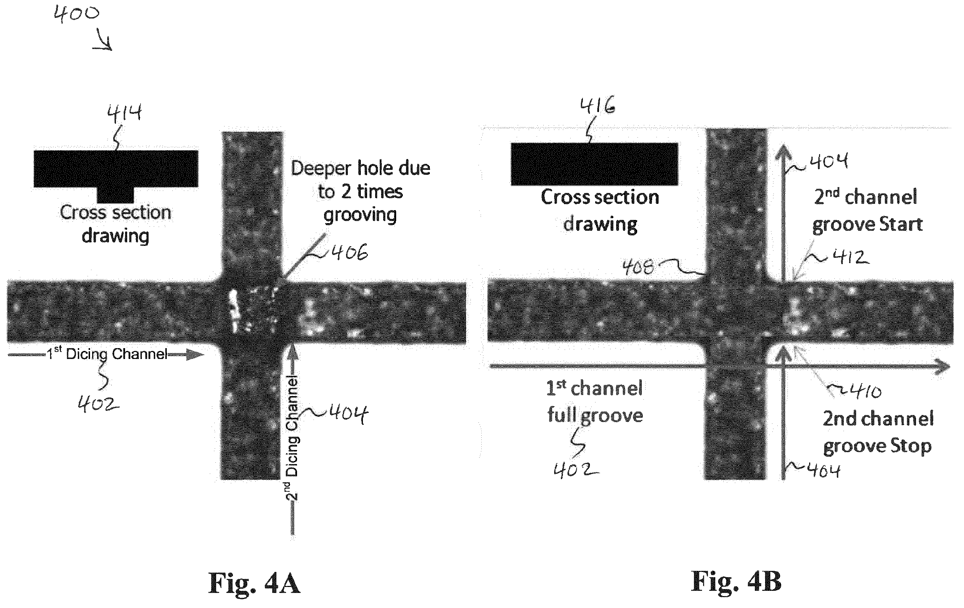

Figure 4 shows examples 400 of intersecting dicing channels created with and without the material removal system 200. Fig. 4A shows a first dicing channel 402, a second dicing channel 404 and a first dicing channel intersection 406. When the material removal beam 204 cuts both the first and second dicing channels 402, 404 with a same material removal beam power level, then the first dicing channel intersection 406 is twice cut and thus twice as deep. This leads to an uneven constant power level cross-section 414, as shown.

However, Fig. 4B shows the first dicing channel 402, the second dicing channel 404 and a second dicing channel intersection 408. When the material removal beam 204 stops 410 cutting the second dicing channel 404 right before the second dicing channel intersection 408 and starts 412 cutting the second dicing channel 404 after the second dicing channel intersection 408, then the second dicing channel intersection 408 is only cut once and thus has a same depth as the first and second dicing channels 402, 404. This leads to an even cross-section 416, as shown.

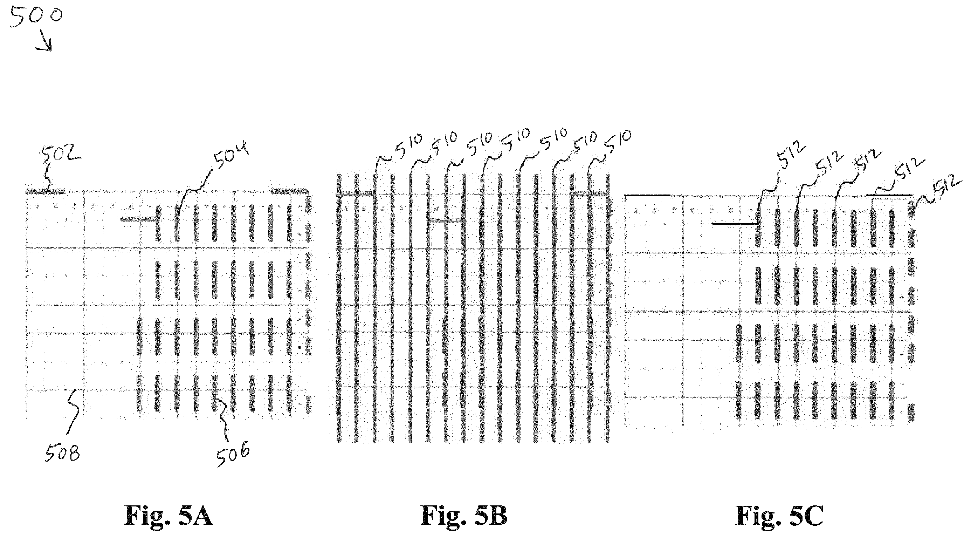

Figure 5 shows an example 500 wafer layout including a heterogeneous set of device structures in the sawlanes and an example application of the material removal system 200 for dicing the example wafer.

Fig. 5A shows a wafer having a first type device structure 502, a second type device structure 504, a third type device structure 506 and empty sawlane structures 508. In Fig. 5A more than 50% of the vertical sawlanes are filled with device structures such as process control modules (PCM's). These PCM can have varying thicknesses and densities. If a constant power material removal beam 204 is applied to these different device structures 502, 504, 506, 508, then the resulting sawlane will have different heights due to these structural differences.

Fig. 5B shows an example set of variable power vertical sawlane cuts 510 by the material removal system's 200 material removal beam 204 so that only one material removal beam 204 cut per vertical sawlane is required.

Fig. 5C shows those portions of the vertical sawlane cuts 510 which were set to a higher material removal beam cutting power level 512 and correspond to the denser or thicker device structures 502, 504, 506.

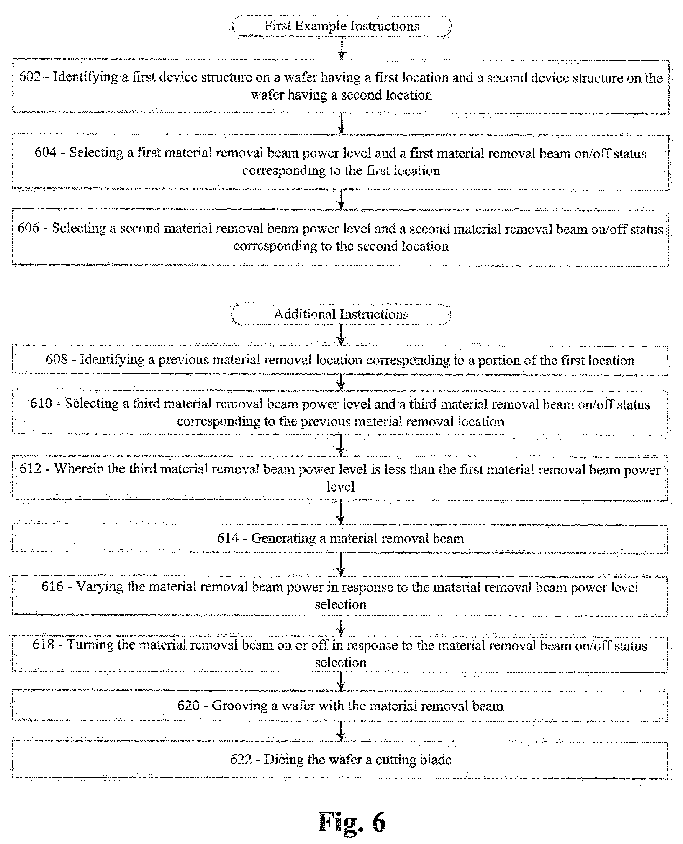

Figure 6 is an example set of instructions for enabling a wafer material removal system. The order in which the instructions are discussed does not limit the order in which other example embodiments implement the instructions. Additionally, in some embodiments the instructions are implemented concurrently.

A first example instruction set begins in 602, by identifying a first device structure on a wafer having a first location and a second device structure on the wafer having a second location. Next, in 604, selecting a first material removal beam power level and a first material removal beam on/off status corresponding to the first location. Then in 606, selecting a second material removal beam power level and a second material removal beam on/off status corresponding to the second location.

The instructions can be augmented with one or more of the following sets of additional instructions, presented in no particular order.

A first set of additional instructions include: 608 - identifying a previous material removal location corresponding to a portion of the first location; 610 - selecting a third material removal beam power level and a third material removal beam on/off status corresponding to the previous material removal location; and 612 - wherein the third material removal beam power level is less than the first material removal beam power level.

A second set of additional instructions include: 614 - generating an material removal beam; 616 - varying the material removal beam power in response to the material removal beam power level selection; and 618 - turning the material removal beam on or off in response to the material removal beam on/off status selection.

A third set of additional instructions include: 620 - grooving a wafer with the material removal beam and 622 - dicing the wafer a cutting blade.

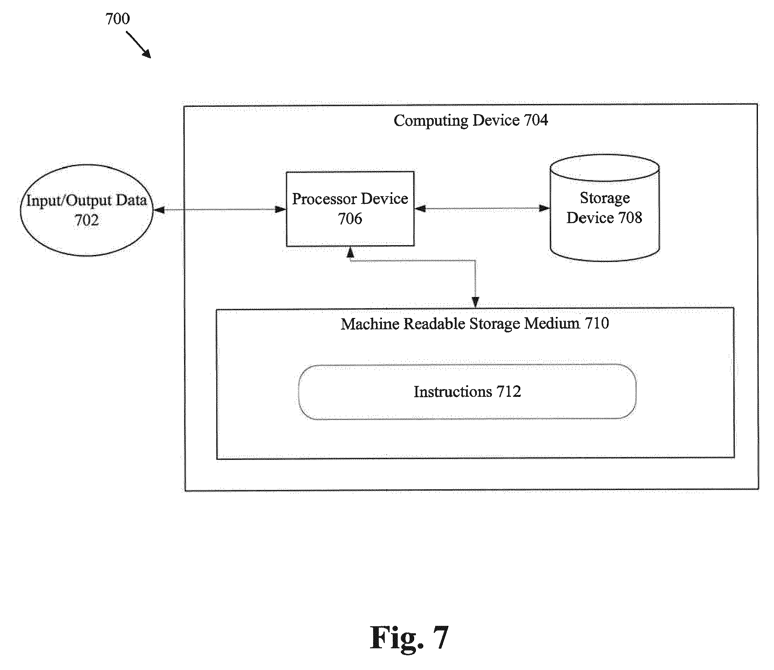

Figure 7 is another example system 700 for hosting instructions for enabling a wafer material removal system. The system 700 shows an input/output data 702 interface with an electronic apparatus 704. The electronic apparatus 704 includes a processor 706, a storage device 708, and a machine-readable storage medium 710. The machine-readable storage medium 710 includes instructions 712 which control how the processor 706 receives input data 702 and transforms the input data into output data 702, using data within the storage device 708. Example instructions 712 stored in the machine-readable storage medium 710 are discussed elsewhere in this specification. The machine-readable storage medium in an alternate example embodiment is a computer-readable storage medium. In one example, the instructions 712 stored in the machine-readable storage medium 710 include those shown in Figure 6.

The processor (such as a central processing unit, CPU, microprocessor, application-specific integrated circuit (ASIC), etc.) controls the overall operation of the storage device (such as random access memory (RAM) for temporary data storage, read only memory (ROM) for permanent data storage, firmware, flash memory, external and internal hard-disk drives, and the like). The processor device communicates with the storage device and non-transient machine-readable storage medium using a bus and performs operations and tasks that implement one or more instructions stored in the machine-readable storage medium. The machine-readable storage medium in an alternate example embodiment is a computer-readable storage medium.

The instructions and/or flowchart steps in the above Figures can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

In other examples, the set of instructions/methods illustrated herein and data and instructions associated therewith are stored in respective storage devices, which are implemented as one or more non-transient machine or computer-readable or computer-usable storage media or mediums. Such computer-readable or computer-usable storage medium or media is (are) considered to be part of an article (or article of manufacture). An article or article of manufacture can refer to any manufactured single component or multiple components. The non-transient machine or computer-usable media or mediums as defined herein excludes signals, but such media or mediums may be capable of receiving and processing information from signals and/or other transient mediums. The storage media include different forms of memory including semiconductor memory devices such as DRAM, or SRAM, Erasable and Programmable Read-Only Memories (EPROMs), Electrically Erasable and Programmable Read-Only Memories (EEPROMs) and flash memories; magnetic disks such as fixed, floppy and removable disks; other magnetic media including tape; and optical media such as Compact Disks (CDs) or Digital Versatile Disks (DVDs).

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

In this specification, example embodiments have been presented in terms of a selected set of details. However, a person of ordinary skill in the art would understand that many other example embodiments may be practiced which include a different selected set of these details. It is intended that the following claims cover all possible example embodiments.

## Claims

1. A system for wafer material removal, comprising:
a wafer structures map, identifying a first device structure having a first location and a second device structure having a second location;
an material removal controller, coupled to the structures map, and having an material removal beam power level output signal and an material removal beam on/off status output signal;
wherein the material removal controller is configured to select a first material removal beam power level and a first material removal beam on/off status corresponding to the first location; and
wherein the material removal controller is configured to select a second material removal beam power level and a second material removal beam on/off status corresponding to the second location.

2. The system of claim 1:
wherein the system is at least one of: a system for wafer grooving or a system for wafer cutting.

3. The system of claim 1:
wherein the wafer structures map identifies the device structures and locations based on information from at least one of: a set of wafer reticles or a scan of a wafer surface.

4. The system of claim 1, wherein the wafer structures map associates with the first device structure: a device structure attribute; a device structure start location; and a device structure stop location, and
wherein the device structure attribute is at least one of: a device structure thickness, device structure density, a device structure material, a device structure depth or a number of device structure layers.

5. The system of claim 1:
wherein the first device structure is at least one of: a sawlane, a sawlane intersection, a process control device, a low-k dielectric material, a metal structure, a multi-layer structure, an integrated circuit, an oxide layer or a polymer layer.

6. The system of claim 1:
further comprising a wafer material removal map, identifying a previous material removal location corresponding to a portion of the first location;
wherein the material removal controller is configured to select a third material removal beam power level and a third material removal beam on/off status corresponding to the previous material removal location;
wherein the third material removal beam power level is less than the first material removal beam power level, and
wherein the previous material removal location corresponding to the portion of the first location is a sawlane intersection.

7. The system of claim 6:
wherein the material removal controller is configured to select the third material removal beam power level and the third material removal beam on/off status corresponding to a device structure depth at the previous material removal location.

8. The system of claim 1:
further comprising an material removal device configured to generate an material removal beam;
wherein the material removal device includes an material removal beam power level modulator coupled to receive the material removal beam power level output signal and in response varying the material removal beam power level; and
wherein the material removal device includes an material removal beam on/off status modulator coupled to receive the material removal beam on/off status output signal and in response turn the material removal beam on or off.

9. The system of claim 8:
wherein the material removal device is at least one of: a cutting device or a grooving device,
wherein the material removal beam is at least one of: a laser beam, an ion beam, a plasma beam, a water beam, general particle beams, or a combination of two or more beams.

10. A method for wafer material removal:
wherein the method comprises the steps:
identifying a first device structure on a wafer having a first location and a second device structure on the wafer having a second location;
selecting a first material removal beam power level and a first material removal beam on/off status corresponding to the first location; and
selecting a second material removal beam power level and a second material removal beam on/off status corresponding to the second location.

11. The method of claim 10, further comprising:
identifying a previous material removal location corresponding to a portion of the first location; and
selecting a third material removal beam power level and a third material removal beam on/off status corresponding to the previous material removal location;
wherein the third material removal beam power level is less than the first material removal beam power level.

12. The method of claim 10, further comprising:
generating an material removal beam;
varying the material removal beam power in response to the material removal beam power level selection; and
turning the material removal beam on or off in response to the material removal beam on/off status selection.

13. The method of claim 12, further comprising:
cutting a wafer with the material removal beam.

14. The method of claim 12, further comprising:
grooving a wafer with the material removal beam; and
dicing the wafer a cutting blade.

15. The method of claim 12, further comprising:
cutting with the material removal beam at least one of: a sawlane, a sawlane intersection, a process control device, a low-k dielectric material, a metal structure, a multi-layer structure, an integrated circuit, an oxide layer or a polymer layer.
